# EUROPEAN PATENT SPECIFICATION

(11) **EP 3 933 838 B1**
(45) Date of publication and mention of the grant of the patent: **12.07.2023**
(21) Application number: 19940798.2
(22) Date of filing: 18.12.2019
(51) Int. Cl.: G11C 8/08, H03K 3/03

(54) **WORD LINE DRIVE CIRCUIT AND STORAGE UNIT**
WORTLEITUNGSSTEUERSCHALTUNG UND SPEICHEREINHEIT
CIRCUIT D'ATTAQUE DE LIGNE DE MOTS ET UNITÉ DE STOCKAGE

(30) Priority: 06.08.2019 CN 201910720182
(43) Date of publication of application: 05.01.2022
(73) Proprietor: Changxin Memory Technologies, Inc., Anhui 230000 (CN)
(72) Inventor: LIU, ChihCheng, Hefei, Anhui 230000 (CN)
(74) Representative: Lavoix
(86) International application number: PCT/CN2019/126394
(87) International publication number: WO 2021/022757

(56) References cited:
- CN-A- 102 097 121
- CN-A- 105 895 146
- CN-A- 106 297 868
- CN-A- 106 683 695
- CN-B- 105 895 146
- US-A1- 2006 146 616
- US-A1- 2011 080 771
- US-A1- 2016 301 398
- US-A1- 2018 034 452
- US-A1- 2019 189 200

## Description

### CROSS-REFERENCE TO RELATED APPLICATIONS

The present disclosure claims priority to Chinese Patent Application No. 201910720182.2, titled "WORDLINE DRIVING CIRCUIT AND MEMORY CELL" and filed on August 6, 2019.

### TECHNICAL FIELD

The present disclosure relates to the field of memory technologies, and more particularly, to a wordline driving circuit and a memory cell.

### BACKGROUND

A memory cell generally includes a wordline driving circuit, and the wordline driving circuit is configured to output a high level or a low level to a wordline of the memory cell, such that the memory cell stores logic "1" or logic "0".

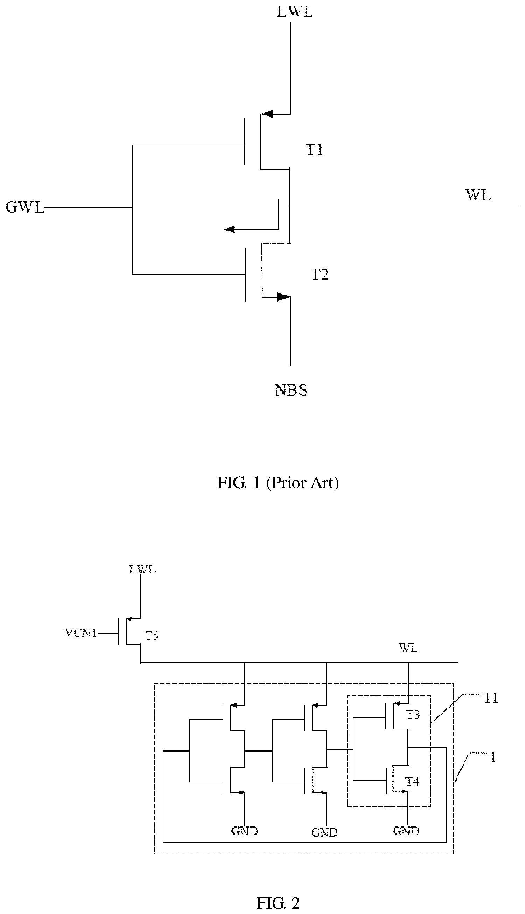

In a related art, as shown in FIG. 1, a diagram showing a circuit structure of a wordline driving circuit in the related art is illustrated. In the related art, the wordline driving circuit generally includes a P-type transistor T1 and an N-type transistor T2. A first terminal of the P-type transistor T1 is connected to a drive voltage terminal LWL, a control terminal of the P-type transistor T1 is connected to a control signal terminal GWL, and a second terminal of the P-type transistor T1 is connected to a wordline signal terminal WL. A first terminal of the N-type transistor T2 is connected to a low-level signal terminal NBS, a control terminal of the N-type transistor T2 is connected to the control signal terminal GWL, and a second terminal of the N-type transistor T2 is connected to the wordline signal terminal WL. When the control signal terminal GWL outputs a low-level signal, the P-type transistor T1 is enabled, and the wordline driving circuit outputs a high-level signal to the wordline signal terminal WL. When the control signal terminal GWL outputs the high-level signal, the N-type transistor T2 is enabled, and the wordline driving circuit outputs the low-level signal to the wordline signal terminal WL.

However, with the miniaturization of the size of the memory cell, the thickness of a gate oxide layer of the N-type transistor T2 in the memory cell is getting thinner and thinner. In the meanwhile, the wordline signal terminal WL is in a higher level state for a long time, such that a GIDL (Gate Induced Drain Leakage, that is, the N-type transistor T2 may have a leakage current along the direction of arrow as shown in FIG. 1) phenomenon may be caused to the N-type transistor T2, which may have a negative effect on the reliability and service life of the N-type transistor T2, and finally may have a negative effect on the reliability and service life of the memory cell.

It is to be noted that the above information disclosed in this Background section is only for enhancement of understanding of the background of the present disclosure and therefore it may contain information that does not form the related art that is already known to a person of ordinary skill in the art.

The document CN 105 895 146 B discloses an example of a wordline driving circuit with low leakage current.

### SUMMARY

According to an aspect of the present invention, there is provided a wordline driving circuit. The wordline driving circuit includes a switching transistor and a ring oscillator. A control terminal of the switching transistor is connected to a first control signal terminal, a first terminal of the switching transistor is connected to a drive voltage terminal, and a second terminal of the switching transistor is connected to a wordline signal terminal. A power terminal of the ring oscillator is connected to the wordline signal terminal, and a ground terminal of the ring oscillator is a ground terminal of the wordline driving circuit.

According to an aspect, there is provided a memory cell, including the above-mentioned wordline driving circuit.

It is to be understood that the above general description and the detailed description below are merely exemplary and explanatory, and do not limit the present disclosure.

### BRIEF DESCRIPTION OF THE DRAWINGS

The accompanying drawings herein are incorporated in and constitute a part of this specification, illustrate embodiments conforming to the present disclosure and, together with the description, serve to explain the principles of the present disclosure. Apparently, the accompanying drawings in the following description show merely some embodiments of the present disclosure, and persons of ordinary skill in the art may still derive other drawings from these accompanying drawings without creative efforts.
FIG. 1 is a diagram showing a circuit structure of a wordline driving circuit in a related art;
FIG. 2 is a schematic structural diagram of a wordline driving circuit according to an exemplary embodiment of the present disclosure;
FIG. 3 illustrates a level state of a wordline signal output terminal in the related art;
FIG. 4 illustrates a level state of a wordline signal terminal of the wordline driving circuit according to an exemplary embodiment of the present disclosure;
FIG. 5 illustrates a timing diagram of a transmission signal from a ring oscillator of the wordline driving circuit according to an exemplary embodiment of the present disclosure;
FIG. 6 is a schematic structural diagram of the wordline driving circuit according to another exemplary embodiment of the present disclosure;
FIG. 7 is a schematic structural diagram of the wordline driving circuit according to still another exemplary embodiment of the present disclosure; and
FIG. 8 is a schematic structural diagram of the wordline driving circuit according to still another exemplary embodiment of the present disclosure.

### DETAILED DESCRIPTION

The exemplary embodiment will now be described more fully with reference to the accompanying drawings. However, the exemplary embodiments can be implemented in a variety of forms and should not be construed as limited to the embodiments set forth herein. Rather, the embodiments are provided so that the present disclosure will be thorough and complete and will fully convey the concepts of exemplary embodiments to those skilled in the art. Throughout the drawings, similar reference signs indicate the same or similar structures, and their detailed description will be omitted.

Although relative terms such as "above" and "below" are used herein to describe a relative relation between one component and another component of icons, these terms are merely for convenience of this specification, for example, the directions of the examples in the accompanying drawings. It is to be understood that when the apparatus of the icon is turned upside down, components described as "above" will become components described as "below". Other relative terms such as "high", "low", "top", "bottom", "left", "right" and so on also have similar meanings. When a certain structure is "above" other structures, it likely means that a certain structure is integrally formed on other structures, or a certain structure is "directly" arranged on other structures, or a certain structure is "indirectly" arranged on other structures by means of another structure.

The terms "one", "a" and "the" are intended to mean that there exists one or more elements/constituent parts/etc. The terms "comprising" and "having" are intended to be inclusive and mean that there may be additional elements/constituent parts/etc. other than the listed elements/constituent parts/etc.

In an exemplary embodiment, a wordline driving circuit is provided. As shown in FIG. 2, a schematic structural diagram of the wordline driving circuit according to an exemplary embodiment is illustrated. The wordline driving circuit includes a switching transistor T5 and a ring oscillator 1. A control terminal of the switching transistor T5 is connected to a first control signal terminal VCN1, a first terminal of the switching transistor T5 is connected to a drive voltage terminal LWL, and a second terminal of the switching transistor T5 is connected to a wordline signal terminal WL. A power terminal of the ring oscillator 1 is connected to the wordline signal terminal WL, and a ground terminal GND of the ring oscillator 1 is a ground terminal of the wordline driving circuit. The switching transistor may be a PMOS transistor.

In this exemplary embodiment, as shown in FIG. 2, the ring oscillator 1 may comprise a plurality of inverters 11 connected end to end, and the number of the inverters is an odd number. It is to be understood that in other exemplary embodiments, the odd number of inverters maybe such as 5, 7, and 9 etc.. The number of the inverters may determine a ripple frequency and a ripple amplitude of a high level on the wordline signal terminal WL. For example, the larger the number of the inverters is, the smaller the ripple frequency is and the larger the ripple amplitude is, and vice versa.

Various embodiments can provide a wordline driving circuit. The wordline driving circuit includes a switching transistor and a ring oscillator. A control terminal of the switching transistor is connected to a first control signal terminal, a first terminal of the switching transistor is connected to a drive voltage terminal, and a second terminal of the switching transistor is connected to a wordline signal terminal. A power terminal of the ring oscillator is connected to the wordline signal terminal, and a ground terminal of the ring oscillator is a ground terminal of the wordline driving circuit. When the switching transistor T5 is enabled, the drive voltage terminal LWL outputs a high-level signal to the wordline signal terminal WL. When the switching transistor T5 is disabled, the transition of an output signal and an input signal from each inverter 11 in the ring oscillator does not change instantaneously between the logic level "1" and the logic level "0", which is a transition process. Under the action of different potentials of the inverter, a second P-type transistor T3 and a second N-type transistor T4 have different enabled states, and have different resistances between the wordline signal terminal WL and the ground terminal GND. As a result, the resistance formed by the ring oscillator may change periodically. Therefore, the ring oscillator can pull down a high level of the wordline signal terminal WL. The wordline driving circuit according to the present disclosure can fundamentally solve the problem of electric leakage for the N-type transistor T2 in the related art.

In this exemplary embodiment, as shown in FIG. 2, the inverter may include an N-type transistor T4 and a P-type transistor T3. A control terminal of the N-type transistor T4 forms an input terminal of the inverter, a first terminal of the N-type transistor T4 forms a ground terminal of the ring oscillator, and a second terminal of the N-type transistor T4 forms an output terminal of the inverter. A control terminal of the P-type transistor T3 is connected to the control terminal of the N-type transistor T4, a first terminal of the P-type transistor T3 is connected to the wordline signal terminal WL, and a second terminal of the P-type transistor T3 is connected to the second terminal of the N-type transistor T4.

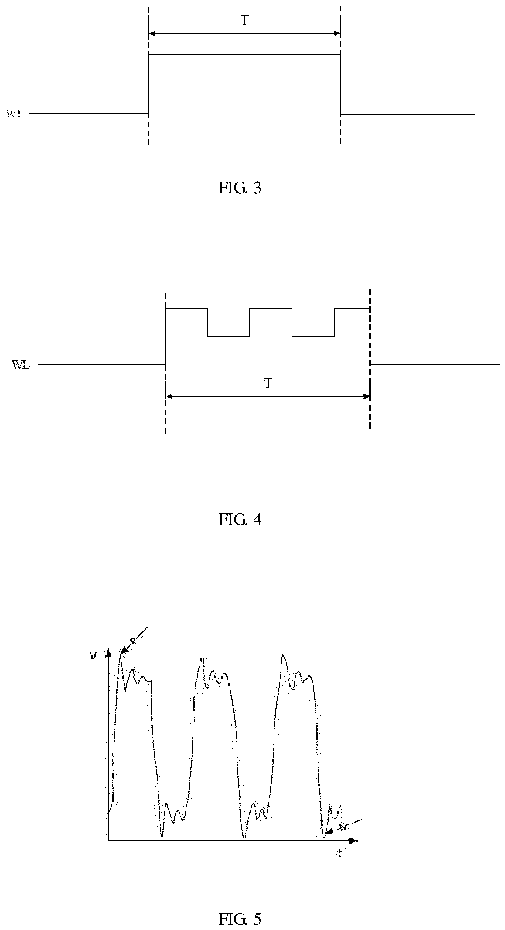

FIG. 3 illustrates a level state of a wordline signal output terminal in the related art. FIG. 4 illustrates a level state of a wordline signal terminal of the wordline driving circuit according to an exemplary embodiment of the present disclosure. In FIG. 1 and FIG. 3, in a time period T, the control signal terminal GWL outputs a low-level signal, the transistor T1 is enabled, and the wordline signal terminal WL maintains a stable high level. In FIG. 2 and FIG. 4, in the time period T, the first control signal terminal VCN1 outputs a low-level signal, and the transistor T5 is enabled. Because the resistance formed by the ring oscillator changes periodically, the wordline signal terminal WL outputs a periodically varying high-level signal. For instance, referring to FIG. 2 and FIG. 4, when the three inverters are enabled at the same time, the resistance between the wordline signal terminal WL and the ground terminal GND is the smallest, which corresponds to a low-level section of the time period T. When the three inverters are disabled at the same time, it corresponds to a high-level section of the time period T. In the actual circuit, flip of the three inverters is not ideally to be turned on or off at the same time, thus a waveform in the corresponding time period T may likely be a square wave, a sawtooth wave, a triangle wave, or the like. Nevertheless, the waveform in the time period T presents a clear periodicity and has a low level and a high level. The value of the high level is equal to that of the wordline signal terminal WL, and the value of the low level is smaller than that of the wordline signal terminal WL. A specific value of the low level may be set based on level flip time of the inverters, the number of the inverters, the size of a transistor in the inverter, the delay of a connection line, and the like. As can be seen by comparing FIG. 3 and FIG. 4, when the wordline signal terminal WL is at a high level, a square-wave signal is changed from a constant signal. Comparing FIG. 1 and FIG. 2, a function of the ring oscillator in FIG. 2 is similar to that of the transistor T2 in FIG. 1. The ring oscillator in FIG. 2 not only can achieve the transition of the wordline signal terminal WL from a low level to a high level and then to the low level, but also can solve the problem of reliability of the transistor caused when the wordline signal terminal WL is maintained at a high level.

In this exemplary embodiment, as shown in FIG. 5, a timing diagram of a transmission signal from the ring oscillator of the wordline driving circuit according to an exemplary embodiment of the present disclosure is illustrated. A pulse signal transmitted by the ring oscillator has positive overshoot and negative overshoot. As shown in FIG. 5, the position pointed by Arrow P is the position of the positive overshoot, and the position pointed by Arrow N is the position of the negative overshoot. An overshoot voltage exists in the position of the positive overshoot and the position of the negative overshoot, which may have a negative effect on the running stability of the wordline driving circuit.

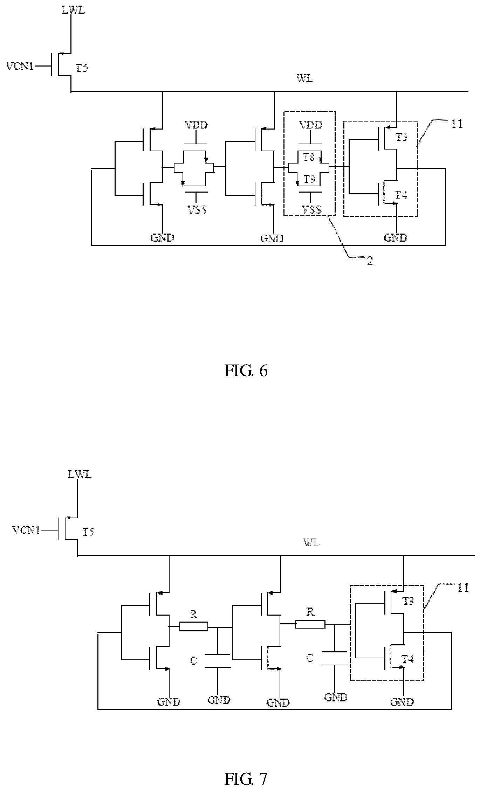

As shown in FIG. 6, a schematic structural diagram of the wordline driving circuit according to still another exemplary embodiment is illustrated. In this exemplary embodiment, the wordline driving circuit may further include a transmission gate 2 arranged between adjacent inverters. The adjacent inverters include a first inverter and a second inverter, and the transmission gate may include a first N-type transistor T8 and a first P-type transistor T9. A control terminal of the first N-type transistor T8 is connected to a high-level signal terminal VDD, a first terminal of the first N-type transistor T8 is connected to an output terminal of the first inverter, and a second terminal of the first N-type transistor T8 is connected to an input terminal of the second inverter. A control terminal of the first P-type transistor T9 is connected to a low-level signal terminal VSS, a first terminal of the first P-type transistor T9 is connected to the output terminal of the first inverter, and a second terminal of the first P-type transistor T9 is connected to the input terminal of the second inverter. The first N-type transistor T8 and the first P-type transistor T9 may form a filter structure, which may avoid the occurrence of the positive overshoot and the negative overshoot in FIG. 6. In the meanwhile, the period of the pulse signal generated by the oscillator can be controlled by setting sizes of transistors T8 and T9. In the meanwhile, the first N-type transistor has no voltage drop to the high level, and the first P-type transistor has no voltage drop to the low level, and thus signal attenuation may be avoided for the ring oscillator.

As shown in FIG. 7, a schematic structural diagram of the wordline driving circuit according to still another exemplary embodiment of the present disclosure is illustrated. In this exemplary embodiment, the ring oscillator may further include a delay cell arranged between two adjacent inverters. The delay cell includes a resistor and a capacitor, and the resistor and the capacitor constitute an RC delayer. The adjacent inverters include a first inverter and a second inverter. An output terminal of the first inverter is connected to an input terminal of the second inverter. The RC filter circuit may include a resistor R and a capacitor C. The resistor R is connected in series between the first inverter and the second inverter. The capacitor C is connected between the input terminal of the second inverter and the ground terminal. This setting may also avoid the occurrence of the positive overshoot and the negative overshoot in FIG. 5.

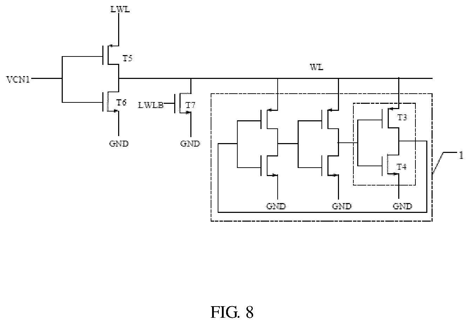

In this exemplary embodiment, as shown in FIG. 8, a schematic structural diagram of the wordline driving circuit according to still another exemplary embodiment is illustrated. The wordline driving circuit may further include a second N-type transistor T7. A control terminal of the second N-type transistor T7 is connected to a second control signal terminal LWLB, a first terminal of the second N-type transistor T7 is connected to the wordline signal terminal WL, and a second terminal of the second N-type transistor T7 is connected to the ground terminal GND. A signal from the second control signal terminal LWLB and a signal from the drive voltage terminal LWL are opposite in phase. The second N-type transistor T7 is enabled in response to the high level of the second control signal terminal LWLB before the drive voltage terminal LWL is initiated, to set the wordline signal terminal WL at the low level. When the drive voltage terminal LWL is at the high level, the transistor T7 will be disabled, wherein the transistor T7 plays a role in controlling an initial working state of the wordline signal terminal WL.

In this exemplary embodiment, as shown in FIG. 8, the wordline driving circuit further includes a third N-type transistor T6. A first terminal of the third N-type transistor T6 is connected to the ground terminal GND, a control terminal of the third N-type transistor T6 is connected to the first control signal terminal VCN1, and a second terminal of the third N-type transistor T6 is connected to the wordline signal terminal WL. When the wordline signal terminal WL needs to output the low-level signal, the first control signal terminal VCN1 turns to the high level. At this moment, the third N-type transistor T6 is enabled under the action of the first control signal terminal VCN1 to connect the wordline signal terminal WL to the ground terminal GND, such that a reset speed of the wordline signal terminal WL is increased. In the meanwhile, because the voltage of the wordline signal terminal WL may be periodically decreased, the wordline driving circuit can reduce the GIDL generated on the N-type transistor T6 by periodically decreasing the voltage of the wordline signal terminal WL, such that the reliability and service life of the N-type transistor T6 may be increased.

This exemplary embodiment also provides a memory cell, including the above-mentioned wordline driving circuit.

The memory cell according to this exemplary embodiment has the same technical features and working principles as the above-mentioned wordline driving circuit, and no detailed description is made here because the above contents have provided a detailed description.

It is to be appreciated that the present disclosure is not limited the embodiments above and illustrated in the accompanying drawings, and that various modifications and changes can be made without departing from the scope thereof. It is intended that the scope of the present invention only be limited by the appended claims.

## Claims

1. A wordline driving circuit, comprising:
a switching transistor (T5) comprising:
a control terminal connected to a first control signal terminal (VCN1),
a first terminal connected to a drive voltage terminal (LWL), and
a second terminal connected to a wordline signal terminal (WL);
**characterized by** further comprising a ring oscillator (1) comprising:
a power terminal connected to the wordline signal terminal, and
a ground terminal also being a ground terminal (GND) of the wordline driving circuit.

2. The wordline driving circuit according to claim 1, wherein the ring oscillator comprises a plurality of inverters (11), and the number of the inverters is greater than or equal to 3 and is an odd number.

3. The wordline driving circuit according to claim 2, wherein the ring oscillator further comprises a transmission gate (2), and the transmission gate is arranged between two adjacent inverters of the plurality of inverters.

4. The wordline driving circuit according to claim 3, wherein the two adjacent inverters comprise a first inverter and a second inverter, and the transmission gate comprises:
a first N-type transistor (T8), a control terminal of the first N-type transistor being connected to a high-level signal terminal, a first terminal of the first N-type transistor being connected to an output terminal of the first inverter, and a second terminal of the first N-type transistor being connected to an input terminal of the second inverter; and
a first P-type transistor (T9), a control terminal of the first P-type transistor being connected to a low-level signal terminal, a first terminal of the first P-type transistor being connected to the output terminal of the first inverter, and a second terminal of the first P-type transistor being connected to the input terminal of the second inverter.

5. The wordline driving circuit according to claim 1, wherein the switching transistor is a P-type metal-oxide-semiconductor logic, PMOS, transistor.

6. The wordline driving circuit according to claim 1, further comprising:
a second N-type transistor (T7), a control terminal of the second N-type transistor being connected to a second control signal terminal (LWLB), a first terminal of the second N-type transistor being connected to the wordline signal terminal, and a second terminal of the second N-type transistor being connected to the ground terminal,
wherein a signal from the second control signal terminal and a signal from the drive voltage terminal are opposite in phase.

7. The wordline driving circuit according to claim 2, wherein the ring oscillator further comprises a delay cell (R, C), and the delay cell is arranged between two adjacent inverters of the plurality of inverters.

8. The wordline driving circuit according to claim 7, wherein the delay cell comprises a resistor (R) and a capacitor (C), and the resistor and the capacitor constitute an RC delayer.

9. The wordline driving circuit according to claim 1, further comprising:
a third N-type transistor (T6), a first terminal of the third N-type transistor being connected to the ground terminal, a control terminal of the third N-type transistor being connected to the first control signal terminal, and a second terminal of the third N-type transistor being connected to the wordline signal terminal.

10. A memory cell, comprising the wordline driving circuit according to any of claims 1 to 9.

## Patentansprüche

1. Wortlinienansteuerschaltung, umfassend:
einen Schalttransistor (T5), umfassend:
einen Steueranschluss, der mit einem ersten Steuersignalanschluss (VCN1) verbunden ist,
einen ersten Anschluss, der mit einem Ansteuerspannungsanschluss (LWL) verbunden ist, und
einen zweiten Anschluss, der mit einem Wortliniensignalanschluss (WL) verbunden ist;
**dadurch gekennzeichnet, dass** er ferner einen Ringoszillator (1) umfasst, umfassend:
einen Stromanschluss, der mit dem Wortliniensignalanschluss verbunden ist, und
einen Erdungsanschluss, der auch ein Erdungsanschluss (GND) der Wortlinienansteuerschaltung ist.

2. Wortlinienansteuerschaltung nach Anspruch 1, wobei der Ringoszillator eine Vielzahl von Wechselrichtern (11) umfasst und die Anzahl der Wechselrichter größer als oder gleich wie 3 und eine ungerade Zahl ist.

3. Wortlinienansteuerschaltung nach Anspruch 2, wobei der Ringoszillator ferner ein Übertragungs-Gate (2) umfasst und das Übertragungs-Gate zwischen zwei benachbarten Wechselrichter der Vielzahl von Wechselrichtern angeordnet ist.

4. Wortlinienansteuerschaltung nach Anspruch 3, wobei die zwei benachbarten Wechselrichter einen ersten Wechselrichter und einen zweiten Wechselrichter umfassen, und das Übertragungs-Gate Folgendes umfasst:
einen ersten N-Kanal-Transistor (T8),
wobei ein Steueranschluss des ersten n-Kanal-Transistors mit einem Hochpegel-Signalanschluss verbunden ist, ein erster Anschluss des ersten N-Kanal-Transistors mit einem Ausgangsanschluss des ersten Wechselrichters verbunden ist und ein zweiter Anschluss des ersten N-Kanal-Transistors mit einem Eingangsanschluss des zweiten Wechselrichters verbunden ist; und
einen ersten P-Kanal-Transistor (T9),
einen Steueranschluss des ersten p-Kanal-Transistors, der mit einem Niedrigpegel-Signalanschluss verbunden ist, wobei ein erster Anschluss des ersten P-Kanal-Transistors mit dem Ausgangsanschluss des ersten Wechselrichters verbunden ist, und ein zweiter Anschluss des ersten P-Kanal-Transistors mit dem Eingangsanschluss des zweiten Wechselrichters verbunden ist.

5. Wortlinienansteuerschaltung nach Anspruch 1, wobei der Schalttransistor ein logischer Transistor pP-Kanal-Metall-Oxid-Halbleiter, PMOS, ist.

6. Wortlinienansteuerschaltung nach Anspruch 1, ferner umfassend:
einen zweiten n-Kanal-Transistor (T7),
wobei ein Steueranschluss des zweiten n-Kanal-Transistors mit einem zweiten Steuersignalanschluss (LWLB) verbunden ist,
wobei ein erster Anschluss des zweiten n-Kanal-Transistors mit dem Wortliniensignalanschluss verbunden ist und ein zweiter Anschluss des zweiten N-Kanal-Transistors mit dem Masseanschluss verbunden ist,
wobei die Phase eines Signals von dem zweiten Steuersignalanschluss und eines Signal von dem Ansteuerspannungsanschluss entgegengesetzt sind.

7. Wortlinienansteuerschaltung nach Anspruch 2, wobei der Ringoszillator ferner eine Verzögerungszelle (R, C) umfasst,
und die Verzögerungszelle zwischen zwei benachbarten Wechselrichtern der Vielzahl von Wechselrichtern angeordnet ist.

8. Wortlinienansteuerschaltung nach Anspruch 7, wobei die Verzögerungszelle einen Widerstand (R) und
einen Kondensator (C) umfasst, und der Widerstand und der Kondensator eine RC-Schicht darstellen.

9. Wortlinienansteuerschaltung nach Anspruch 1, ferner umfassend:
einen dritten n-Kanal-Transistor (T6),
wobei ein erster Anschluss des dritten N-Kanal-Transistors mit dem Masseanschluss verbunden ist, ein Steueranschluss des dritten N-Kanal-Transistors mit dem ersten Steuersignalanschluss verbunden ist, und ein zweiter Anschluss des dritten N-Kanal-Transistors mit dem Wortliniensignalanschluss verbunden ist.

10. Speicherzelle, umfassend die Wortlinienansteuerschaltung nach einem der Ansprüche 1 bis 9.

## Revendications

1. Circuit d'attaque de ligne de mots, comprenant :
un transistor de commutation (T5) comprenant :
une borne de commande connectée à une première borne de signal de commande (VCN1),
une première borne connectée à une borne de tension d'attaque (LWL), et
une seconde borne connectée à une borne de signal de ligne de mots (WL) ; **caractérisé en ce qu'**il comprend en outre un oscillateur annulaire (1) comprenant :
une borne de puissance connectée à la borne de signal de ligne de mots, et
une borne de terre qui est également une borne de terre (GND)
du circuit d'attaque de ligne de mots.

2. Circuit d'attaque de ligne de mots selon la revendication 1, dans lequel l'oscillateur annulaire comprend une pluralité d'inverseurs (11) et le nombre d'inverseurs est supérieur ou égal à 3 et est un nombre impair.

3. Circuit d'attaque de ligne de mots selon la revendication 2, dans lequel l'oscillateur annulaire comprend en outre une porte de transmission (2), et la porte de transmission est disposée entre deux inverseurs adjacents de la pluralité d'inverseurs.

4. Circuit d'attaque de ligne de mots selon la revendication 3, dans lequel les deux inverseurs adjacents comprennent un premier inverseur et un second inverseur, et la porte de transmission comprend :
un premier transistor de type N (T8),
une borne de commande du premier transistor de type N étant connectée à une une borne de signal de haut niveau, une première borne du premier transistor de type N étant connectée à une borne de sortie du premier inverseur, et une seconde borne du premier transistor de type N étant connectée à une borne d'entrée du second inverseur ; et
un premier transistor de type P (T9),
une borne de commande du premier transistor de type P étant connectée à une borne de signal de bas niveau, une première borne du premier transistor de type P étant connectée à la borne de sortie du premier inverseur, et une seconde borne du premier transistor de type P étant connectée à la borne d'entrée du second inverseur.

5. Circuit d'attaque de ligne de mots selon la revendication 1, dans lequel le transistor de commutation est un transistor logique semi-conducteur d'oxyde de métal de type P (PMOS).

6. Circuit d'attaque de ligne de mots selon la revendication 1, comprenant en outre :
un deuxième transistor de type N (T7),
une borne de commande du deuxième transistor de type N étant connectée à une seconde borne de signal de commande (LWLB),
une première borne du deuxième transistor de type N étant connectée à la borne de signal de ligne de mots, et une seconde borne du deuxième transistor de type N étant connectée à la borne de masse,
dans lequel un signal provenant de la seconde borne de signal de commande et un signal provenant de la borne de tension d'attaque sont opposés en phase.

7. Circuit d'attaque de ligne de mots selon la revendication 2, dans lequel l'oscillateur annulaire comprend en outre une cellule à retard (R, C),
et la cellule à retard est disposée entre deux inverseurs adjacents de la pluralité d'inverseurs.

8. Circuit d'attaque de ligne de mots selon la revendication 7, dans lequel la cellule à retard comprend une résistance (R) et
un condensateur (C), et la résistance et le condensateur constituent un retardateur RC.

9. Circuit d'attaque de ligne de mots selon la revendication 1, comprenant en outre :
un troisième transistor de type N (T6),
une première borne du troisième transistor de type N étant connectée à la borne de masse, une borne de commande du troisième transistor de type N étant connectée à la première borne de signal de commande, et une seconde borne du troisième transistor de type N étant connectée à la borne de signal de ligne de mots.

10. Cellule de mémoire comprenant le circuit d'attaque de ligne de mots selon l'une quelconque des revendications 1 à 9.
